# EUROPEAN PATENT SPECIFICATION

(11) **EP 1 688 793 B1**
(45) Date of publication and mention of the grant of the patent: **24.11.2010**
(21) Application number: 04773036.1
(22) Date of filing: 14.09.2004
(51) Int. Cl.: G03F 7/039, G03F 7/022

(54) **CHEMICALLY AMPLIFIED PHOTOSENSITIVE RESIN COMPOSITION FOR FORMING A THICK FILM OR ULTRATHICK FILM**
CHEMISCH VERSTÄRKTE LICHTEMPFINDLICHE HARZZUSAMMENSETZUNG ZUR HERSTELLUNG EINES DICKFILMS ODER ULTRADICKFILMS
COMPOSITION DE RESINE PHOTOSENSIBLE CHIMIQUEMENT AMPLIFIEE POUR LA FABRICATION D'UN FILM EPAIS OU ULTRA-EPAIS

(30) Priority: 31.10.2003 JP 2003373069
(43) Date of publication of application: 09.08.2006
(73) Proprietor: AZ Electronic Materials (Japan) K.K., Tokyo 113-0021 (JP); AZ Electronic Materials USA Corp., Somerville, NJ 08876 (US)
(72) Inventor: MAKII, Toshimichi, c/o Clariant (Japan) K.K., Ogasa-gun, Shizuoka 437-1496 (JP); NISHIWAKI, Yoshinori, Haibara-gun, Shizuoka 421-0301 (JP); AKASHI, Kazumichi, c/o Clariant (Japan) K.K., Ogasa-gun, Shizuoka 437-1496 (JP)
(74) Representative: Isenbruck, Günter
(86) International application number: PCT/JP2004/013354
(87) International publication number: WO 2005/043247

(56) References cited:
- EP-A- 1 562 077
- EP-A1- 0 884 647
- EP-A1- 0 908 783
- WO-A2-03/085455
- JP-A- 1 003 647
- JP-A- 7 219 216
- JP-A- 9 015 850
- JP-A- 10 204 125
- JP-A- 10 207 057
- JP-A- 63 010 153
- JP-A- 2001 174 990
- JP-A- 2001 312 060
- JP-A- 2002 258 479
- JP-A- 2002 365 799
- US-A- 5 942 367

## Description

### Field of the Invention

The present invention relates to a photosensitive resin composition, more specifically to a chemically amplified photosensitive resin composition suitable for forming a thick film and a super thick film appropriately used in producing a semiconductor device, a flat panel display (FPD), a circuit board, a magnetic head, and the like, particularly in forming the magnetic pole of a magnetic head and forming a protruding electrode called a "bump" that is used as a connecting terminal of a large scale integrated circuit (LSI).

### Background of the Invention

Photolithographic technologies have so far been employed for forming microelements or carrying out a fine processing in wide fields including the production of semiconductor integrated circuits such as LSIs, the display surfaces of FPDs, and the like, and the production of circuit boards for thermal heads and the like. In photolithographic technologies, positive- or negative-working photosensitive resin compositions are used to form resist patterns. Of these photosensitive resin compositions, compositions containing an alkali soluble resin and a quinonediazide compound as a photosensitizing agent are widely employed as a positive-working photosensitive resin composition. As to these compositions a variety of constitutions are described, for example, as "novolak resins/quinonediazide compounds" in many documents (e.g., see patent documents 1 to 4 below). The compositions containing a novolak resin and a quinonediazide compound have been investigated from both the standpoints of novolak resins and quinonediazide compounds.
Patent Document 1: Japanese Patent Application Publication (JP-B) No. 54-23570 (p. 1)
Patent Document 2: JP-B 56-30850 (p. 1)
Patent Document 3: Japanese Patent Application Laid-Open (JP-A) No. 55-73045 (pp. 1 to 4)
Patent Document 4: JP-A 61-205933 (pp. 1 and 3 to 5)

Incidentally, in the fields of the magnetic head, bump, and the like where a thick film processing is required, the formation of the resist pattern having a high aspect ratio and perpendicular wall is needed. The aforementioned conventional photoresists, however, have problems of, for example, not sufficiently holding resolution and sensitivity caused by the decline of the optical transparency in a film due to the thickening of the film, or not being capable of providing a desired resist pattern. As such, improvements against these problems are required.

As the photosensitive resin composition for the dry film system which can form resist patterns with thick film thickness, there have been hitherto known a photosensitive resin composition comprising a novolak resin, an acetal compound which has repeating acetal portions in the main chain and in which each α-carbon atom of the alcohol components in the acetal portions comprises an aliphatic carbon, and an acid generating agent (see patent document 5 below); a photosensitive resin composition comprising an alkali soluble resin such as a novolak resin, an acetal compound, an acid generating agent, and specific additive components such as an alkyl acrylate (see patent document 6 below); and a photosensitive resin composition comprising an alkali soluble resin such as a novolak resin, an acetal compound, and an acid generating agent (see patent document 7 below). In addition, there are also known as the photosensitive resin composition containing an acetal compound and an acid generating agent, a photosensitive resin composition comprising a novolak resin containing three different kinds of phenols, an acetal compound and an acid generating agent (see patent document 8 below); a photosensitive resin composition comprising a novolak resin having an acetal bond in the molecule and an acid generating agent (see patent document 9 below), and a photoresist comprising a novolak resin, an acetal compound (chlorobenzaldehyde-diphenoxyethylacetal) and an acid generating agent (2-alkoxyphenyl-4,6-bis(trichloromethyl)-s-triazine) (see patent document 10 below). Furthermore, there is also disclosed as the photosensitive resin composition suitable for forming resist layer with thick or super thick thickness of 10 µm or more appropriate to the formation of a bump, a photosensitive resin composition comprising a polymer having an acid dissociating functional group, a polyvinyl lower alkyl ether and an acid generating agent (see patent document 11 below), and there is also disclosed as the photosensitive resin composition suitable for forming a thick resist film of 3 µm or more appropriate to the production of a magnetic head, a photosensitive resin composition comprising an alkali soluble novolak resin in which some of the hydrogen atoms in the entire phenolic hydroxyl groups are replaced by 1,2-naphtoquinonediazidesulfonyl groups and acid generating agent (see patent document 12 below). However, for instance, in order to adapt to a super thick film having a film thickness of from 20 to 100 µm, there are required good pattern reproducibility and stability of pattern shape and of a change in developing time against the leaving time after exposed to light, as well as high resolution to form a fine rectangular pattern with a high aspect ratio, and further improvements in heat resistance of a resultant pattern and in throughput (yield per unit time) during production from the viewpoint of production cost. Even in such situations, still more improvement against the problem is desired.
Patent Document 5: JP-A 53-133429 (pp. 1 to 17)
Patent Document 6: JP-A 57-37349 (pp. 1 to 6)
Patent Document 7: JP-A 58-114031 (pp. 1 to 5)
Patent Document 8: JP-A 62-124556 (pp. 1 to 4)
Patent Document 9: JP-A 62-215947 (pp. 1 and 3 to 5)
Patent Document 10: JP-A 4-182650 (pp. 1 and 3 to 5)
Patent Document 11: JP-A 2001-281863 (pp. 2 and 4 to 9)
Patent Document 12: JP-A 2001-312060 (pp. 2 to 7)
EP-A 0 884 647 discloses an image forming material comprising a metal support having an anodization layer on its surface, and provided on the anodization layer, a light sensitive layer containing a first compound capable of generating an acid on exposure of an actinic light, a second compound having a group cross-linking by an acid or a third compound having a chemical bond capable of being decomposed by an acid, and an infrared absorber, wherein the thickness of the anodization layer is 10 to 60 mg/dm².
Further phororesist compositions are disclosed in US 5,942,367, EP-A 1 562 077, JP-A 7-219216, JP-A 9-15850, JP-A 63-10153, JP-A 64-3647, JP-A 10-207057 and JP-A 10-204125.

### Disclosure of the Invention

### Problems to be solved by the Invention

Taking into consideration of the above-described circumstances, an object of the present invention is to provide a chemically amplified photosensitive resin composition which has high sensitivity and high residual film properties, and further which is excellent in coating properties as well, has high resolution, and enables to form a good pattern, and which also gives excellent heat resistance of a resulting pattern, in a chemically amplified photosensitive resin composition suitable for thick film and super thick film processes.

### Means for Solving the Problems

The present inventors made exceptional efforts toward studies and examinations, and, as a result, have found that the above-described object can be attained through the use of a specified photosensitive resin composition comprising an alkali soluble novolak resin, a resin or compound which in itself is insoluble or slightly soluble in alkali, but becomes soluble in alkali by the action of an acid, a compound that generates an acid by irradiating with a radiation (that is acid generating agent), a photosensitizing agent containing a quinonediazide group and a specific crosslinking agent, in a chemically amplified photosensitive resin composition to be used in a thick film process having a thickness, for example, exceeding 10 µm or a super thick film process having a thickness, for example, exceeding 20 µm, thereby accomplishing the present invention.

In other words, the present invention relates to a chemically amplified photosensitive resin composition comprising an alkali soluble novolak resin (A), a resin or compound (B) which in itself is insoluble or slightly soluble in alkali, but becomes soluble in alkali by the action of an acid, an acid generating agent (C), a photosensitizing agent containing a quinonediazide group (D), a crosslinking agent (F) containing at least two vinyloxyalkylester groups and, optionally an alkali soluble acrylic resin (E) to improve the film quality, wherein the ratio by weight of said components (A) : (B) : (C) : (D) : (E) : (F) is 100 : 1 to 50 : 0.02 to 10 : 1 to 30 : 0 to 200 : 1 to 10.

Hereinafter, the present invention will be set forth in more detail.

The alkali soluble novolak resins (A) used in the chemically amplified photosensitive resin composition of the present invention can be any of resins as long conventionally well-known alkali soluble novolak resins used in a photosensitive resin composition comprising an alkali soluble resin and a photosensitizing agent containing a quinonediazide group, and are not particularly limited. A novolak resin preferably used in the present invention is obtained by polycondensation of a single species or a mixture of the plural species of various phenols with an aldehyde such as formalin.

Examples of phenols constituting the novolak resin include phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylenebisphenol, methylenebis-p-cresol, resorcin, catechol, 2-methylresorcin, 4-methylresorcin, o-chlorophenol, m-chlorophenol, p-chlorophenol, 2,3-dichlorophenol, m-methoxyphenol, p-methoxyphenol, p-butoxyphenol, o-ethylphenol, m-ethylphenol, p-ethylphenol, 2,3-diethylphenol, 2,5-diethylphenol, p-isopropylphenol, α-naphthol, β-naphthol, and the like. These can be used singly or as a mixture of plural species. Of these, the use of a combination of two or more species of phenol compounds, such as the simultaneous use of two species, m-cresol and p-cresol, frequently leads to a more preferred result.

In addition, Examples of the aldehydes include paraformaldehyde, acetaldehyde, benzaldehyde, hydroxybenzaldehyde, chloroacetaldehyde, and the like as well as formalin. These can be used singly or as a mixture of the plural species.

The weight average molecular weight of the alkali soluble novolak resin (A) used for the chemically amplified photosensitive resin composition of the present invention is preferably from 5,000 to 100,000 as determined by polystyrene standards, and more preferably from 5,000 to 50,000 as determined by polystyrene standards.

Examples of the resin or compound (B) which in itself is insoluble or slightly soluble in alkali, but becomes soluble in alkali by the action of an acid, to be used in the chemically amplified photosensitive resin composition of the present invention include acetal resins or acetal compounds. The aforementioned acetal resins or acetal compounds to be used in the present invention are not particularly limited as long as they comprise acetal resins or acetal compounds including the acetal compounds described in aforementioned patent documents 5 to 10 indicated in the prior art, but the acetal resins or acetal compounds having the constituent unit represented by the general formula (I) below in the molecule are preferred: 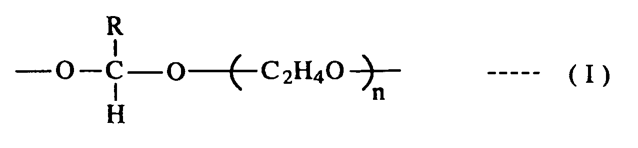 wherein R represents an alkyl group having 1 to 20 carbon atoms, preferably represents a saturated alkyl group having 3 to 10 carbon atoms. Specific examples of the more preferable alkyl group include an isopropyl group, a tert-butyl group, a 1-methylpropyl group and a 1-ethylpropyl group. n is an integer of from 1 to 10, preferably from 2 to 4.

The range of the average molecular weight of an acetal resin or compound having the constituent unit represented by the general formula (I) in the molecule is preferably from 100 to 10,000, more preferably from 200 to 5,000 as determined by polystyrene standards.

As the acetal resin or acetal compound represented by the general formula (I) above, there is typically illustrated a polycondensation product having the repeating unit represented by the general formula (I) which is obtained by reacting, for example, an aldehyde: RCHO, a dialcohol: RCH(OH)₂, or an acetal: RCH(OR¹)₂ (wherein R represents the group as defined above, and R¹ represents an alkyl group.) with ethylene glycol or polyethylene glycol represented by the general formula: 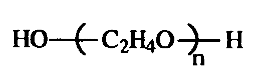 wherein n represents the integer as defined above,
at 50°C under reduced pressure in the presence of an acid catalyst.

Examples of the resin or compound (B) which in itself is insoluble or slightly soluble in alkali, but becomes soluble in alkali by the action of an acid, to be used in the chemically amplified photosensitive resin composition of the present invention additionally include resins that have a decomposable protecting group by the action of an acid and become soluble in alkali after decomposed by the action of an acid. Example of the base resin soluble in alkali prior to be protected by the aforementioned protecting group includes the resins having a phenolic hydroxyl group and/or a carboxyl group as an alkali soluble group. More particularly, examples of the base resin include vinylphenol resins; isopropenylphenol resins; copolymers of vinylphenol, (meth)acrylic acid or derivatives thereof, acrylonitrile and styrene or derivatives thereof; copolymers of isopropenylphenol, methacrylic acid or derivatives thereof, acrylonitrile and styrene derivatives thereof; copolymers of styrene or a derivative thereof with an acrylic acid ester, a methacrylic acid ester, acrylic acid, methacrylic acid, maleic acid, maleic anhydride, or the like; polymers of a (meth)acrylic acid derivative having a carboxyl group or copolymers formed by use of the aforementioned (meth)acrylic acid derivative such as (meth)acrylic acid as one monomer; and resins in which a silicon-containing compound is introduced into the chain of the polymers described above. The base resin wherein at least a part of the hydrogen atom in the hydroxyl group or carboxyl group is modified by the decomposable protecting group by the action of an acid is used as the resin (B) in the present invention. As the protecting groups there are illustrated groups which can form an acetal structure, an ether structure, and an ester structure with a hydroxyl group or a carboxyl group. The preferred examples of the protecting group include a 1-ethoxyethyl group, a tert-butoxycarbonyl group, and a tert-butoxy ester group.

In the present invention, the resin or compound (B) which in itself is insoluble or slightly soluble in alkali, but becomes soluble in alkali by the action of an acid is normally used in an amount of from 1 to 50 parts by weight, preferably from 1 to 30 parts by weight, based on 100 parts by weight of the alkali soluble novolak resin (A).

As a compound that generates an acid by irradiating with a radiation and thus is the acid generating agent (C) to be used in the chemically amplified photosensitive resin composition of the present invention, any compound can be used as long as it generates an acid by irradiating with a radiation. Such acid generating agents typically include those conventionally used as an acid generating agent in a chemically amplified resist. The acid generating agent includes onium ions such as an iodonium salt, a sulfonium salt, a diazonium salt, an ammonium salt, and a pyridinium salt; halogen-containing compounds such as a hydrocarbon compound containing a haloalkyl group and a heterocyclic compound containing a haloalkyl group (a halomethyltriazine derivative or the like); diazoketone compounds such as a 1,3-diketo-2-diazo compound, a diazobenzoquinone compound, and a diazonaphthoquinone compound; sulfone compounds such as β-ketosulfone, and β-sulfonylsulfone; and sulfonic acid compounds such as an alkylsulfonic acid ester, a haloalkylsulfonic acid ester, an arylsulfonic acid ester, and an iminosulfonate. These can be employed singly or as a mixture of two or more species. In the present invention, the acid generating agent (C) is normally used in an amount of from 0.02 to 10 parts by weight, preferably from 0.5 to 3.0 parts by weight, based on 100 parts by weight of the alkali soluble novolak resin.

Particularly preferred examples of the acid generating agent to be used in the present invention include triazine-based acid generating agents typified by 2-[2-(5-methylfuran-2-yl)ethenyl]-4,6-bis-(trichloromethyl)-s-triazine or cyano-based acid generating agents typified by 5-methylsulfonyloxyimino-5H-thiophene-2-ylidene-2-methylphenylacetonitrile.

The photosensitizing agent (D) containing a quinonediazide group to be used in a chemically amplified photosensitive resin compound of the present invention includes any species as long as they are photosensitizing agents containing a quinonediazide group. For instance, a photosensitizing agent is preferred that is obtained by reacting a quinonediazidesulfonyl halide such as naphthoquinonediazidesulfonyl chloride or benzoquinonediazidesulfonyl chloride with a low molecular-weight compound or a high molecular-weight compound having a functional group which can be condensed with the acid halide thereof. Examples of the functional group which can be condensed with an acid halide include a hydroxyl group, an amino group and the like, and in particular the hydroxyl group is preferred. In the present invention, such a photosensitizing agent containing a quinonediazide group is normally used in an amount of 1 to 30 parts by weight, preferably 3 to 15 parts by weight, based on 100 parts by weight of the alkali soluble resin component in the chemically amplified photosensitive resin composition. In the chemically amplified photosensitive resin composition of the present invention, the above-described photosensitizing agents containing a quinonediazide group may be used singly or in combination of two or more species.

On the other hand, as the alkali soluble acrylic resin (E) to be used in the present invention there are illustrated an alkali soluble polyacrylic acid ester (E-1), an alkali soluble polymethacrylic acid ester (E-2), and an alkali soluble poly(acrylic acid ester/methacrylic acid ester) (E-3) containing the constituent unit both at least one kind of an acrylic acid ester and at least one kind of a methacrylic acid ester. These acrylic resins can be used singly or in combination of two or more species. In the present invention, the alkali soluble acrylic resin (E) may be used, as required, and is used in an amount of from 0 to 200 parts by weight, normally from 2 to 200 parts by weight, preferably from 10 to 50 parts by weight, based on 100 parts of the alkali soluble novolak resin (A). In the present invention, the use of an alkali soluble acrylic resin provides the effect of improving the heat resistance of a resist film.

The acrylic resins are preferably used that contain, as a copolymer component, an organic acid monomer and an acrylic acid ester or a methacrylic acid ester having a hydroxyl group in the side chain thereof as a monomer component to make the resin soluble in alkali. However a copolymer component that imparts alkali solubility to the resin is by no means limited to such an organic acid monomer, or such an acrylic acid ester or a methacrylic acid ester having a hydroxyl group in the side chain thereof.

Examples of the monomer components constituting the above-mentioned alkali soluble polyacrylic acid ester, polymethacrylic acid ester, or poly(acrylic acid ester/methacrylic acid ester) include an acrylic acid ester, a methacrylic acid ester, an organic acid monomer and other copolymerizable monomers. Of the monomer components constituting these polymers, preferred examples of the acrylic acid esters, methacrylic acid esters, and organic acid monomers are illustrated below.

### Acrylic acid esters:

Methyl acrylate, ethyl acrylate, n-propyl acrylate, n-butyl acrylate, n-hexyl acrylate, isopropyl acrylate, isobutyl acrylate, t-butyl acrylate, cyclohexyl acrylate, benzyl acrylate, 2-chloroethyl acrylate, methyl-α-chloroacrylate, phenyl-α-bromoacrylate, and the like.

### Methacrylic acid esters:

Methyl methacrylate, ethyl methacrylate, n-propyl methacrylate, n-butyl methacrylate, n-hexyl methacrylate, isopropyl methacrylate, isobutyl methacrylate, t-butyl methacrylate, cyclohexyl methacrylate, benzyl methacrylate, phenyl methacrylate, 1-phenylethyl methacrylate, 2-phenylethyl methacrylate, furfuryl methacrylate, diphenylmethyl methacrylate, pentachlorophenyl methacrylate, naphthyl methacrylate, isoboronyl methacrylate, hydroxyethyl methacrylate, hydroxypropyl methacrylate, and the like.

### Organic acid monomers:

Monocarboxylic acids such as acrylic acid, methacrylic acid, and crotonic acid, dicarboxylic acids and acid anhydrides thereof, such as itaconic acid, maleic acid, fumaric acid, citraconic acid and mesaconic acid, 2-acryloyl hydrogen phthalate, 2-acryloyloxypropyl hydrogen phthalate, and the like.

In addition, the other copolymerizable monomers include maleic acid diesters, fumaric acid diesters, styrene and styrene derivatives such as, for example, 4-fluorostyrene, 2,5-difluorostyrene, 2,4-difluorostyrene, p-isopropylstyrene, o-chlorostyrene, 4-acetylstyrene, 4-benzoylstyrene, 4-bromostyrene, 4-butoxycarbonylstyrene, 4-butoxymethylstyrene, 4-butylstyrene, 4-ethylstyrene, 4-hexylstyrene, 4-methoxystyrene, 4-methylstyrene, 2,4-dimethylstyrene, 2,5-dimethylstyrene, 2,4,5-trimethylstyrene, 4-phenylstyrene, 4-proxystyrene and the like, acrylonitrile, (meth)acrylamide, vinyl acetate, vinyl chloride, vinylidene chloride, and the like. As the other copolymerizable monomers, styrene and styrene derivatives are preferred. These other copolymerizable monomers may be used as required, and the amount thereof used within the range wherein the object of the present invention can be attained by the acrylic resin.

Preferred examples of the alkali soluble acrylic resins to be used in the chemically amplified photosensitive resin composition of the present invention include a copolymer comprising a constituent unit derived from (meth)acrylic acid and/or a constituent unit derived from hydroxymethacrylate, a constituent unit derived from an alkyl methacrylate and further, if necessary, a constituent unit derived from styrene; more preferred a copolymer comprising a constituent unit derived from (meth)acrylic acid or hydroxyethyl methacrylate, a constituent unit derived from methyl methacrylate, and a constituent unit derived from n-butyl acrylate, and further, if necessary, a constituent unit derived from styrene. The range of the average molecular weight of the acrylic resin of the present invention is preferably from 2,000 to 200,000, more preferably 20,000 to 100,000 as determined by polystyrene standards.

In the chemically amplified photosensitive resin composition of the present invention, a crosslinking agent is used to improve film quality. In the present invention, the use of the crosslinking agent improves the surface roughness or reduction of the film thickness of the resist film. The crosslinking compound (F) of the present invention contains at least two vinyloxyalkyl ester groups. The compounds containing at least two vinyloxyalkyl ester groups include, for example, tris[4-(vinyloxy)butyl]trimellitate and bis[4-(vinyloxy)butyl]isophthalate. In the present invention, the amount of the compound (F) containing at least two vinyloxyalkyl ester groups is from 1 to 10 parts by weight, based on 100 parts by weight of the alkali soluble resin component in a chemically amplified photosensitive resin composition. In the chemically amplified photosensitive resin composition of the present invention, the above-mentioned compounds containing vinyloxyalkyl ester groups may be contained singly or in combination of two or more species.

In addition, in the chemically amplified photosensitive resin composition of the present invention, other crosslinking agents can also be employed to improve film quality other than the above-mentioned compounds containing vinyloxyalkyl ester groups. The examples of the other crosslinking agents for film quality improvement include, in addition to a melamine-based crosslinking agent, a benzoguanamine-based crosslinking agent and an urea-based crosslinking agent, an alkoxyalkylated melamine resin, an alkoxyalkylated urea resin, pyromellitic acid anhydride, benzophenontetracarboxylic acid anhydride, and tetracarboxylic acid anhydride of tetrahydrofuran.

In the photosensitive resin composition of the present invention, there may be incorporated, if necessary, dyes, adhesion aids, surfactants and the like. Examples of the dyes include methyl violet, crystal violet, malachite green, and the like. Examples of the adhesive aids include an alkyl imidazoline, butyric acid, an alkylic acid, polyhydroxystyrene, polyvinylmethyl ether, t-butyl novolak, an epoxysilane, an epoxy polymer, a silane, etc. Further, examples of the surfactants include nonionic surfactants such as polyglycols and the derivatives thereof, i.e., polypropylene glycol or polyoxyethylene lauryl ether; fluorine-containing surfactants such as Fluorad (trade name; product of Sumitomo 3M Co., Ltd.), Megafac (trade name; product of Dai-Nippon Ink & Chemicals, Inc.), Surflon (trade name; product of Asahi Glass Company, Ltd.) and organosiloxane surfactants such as KP341 (trade name; product of Shin-Etsu Chemical Co., Ltd.).

The alkali soluble novolak resin, the resin or compound which in itself is insoluble or slightly soluble in alkali but becomes soluble in alkali by the action of an acid, the acid generating agent, the photosensitizing agent containing a quinonediazide group, the alkali soluble acrylic resin, the crosslinking agent for film quality improvement and other additives, according to the present invention, are dissolved in a solvent to prepare a photosensitive resin composition. Example of the solvent used to dissolve the constitution materials of the photosensitive resin composition include ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactic acid esters such as methyl lactate and ethyl lactate; aromatic hydrocarbons such as toluene and xylene; ketones such as methylethyl ketone, 2-heptanone and cyclohexanone; amides such as N,N-dimethylacetamide and N-methylpyrrolidone; lactones such as γ-butyrolactone; and the like. These solvents can be used singly or as a mixture of two or more species.

Incidentally, the bonding methods in the semiconductor packaging techniques include the wire bonding method in which a chip is bonded to an exterior circuit using a wire, the Tape Automated Bonding (TAB) method in which a chip is bonded to an exterior circuit using a metal protrusion (bump), and the Flip Chip (FC) method. The bump forming technique is used in both the TAB method and the FC method, in which bump formation is conducted on either the electrode on a chip or the electrode on a substrate. A bump is normally formed by a process that involves steps of laminating a barrier metal to be an electric conductive layer on a silicon wafer or the like on which LSI elements are processed, applying thereon a photosensitive composition, so called resist to form a photoresist film, exposing the film to light through a mask so that a portion in which the bump is formed is opened and developing to form a pattern on the metal, depositing an electrode material such as gold or copper by electrolytic plating by using the pattern as a mold, peeling off the resin portion, removing the barrier metal by etching, cutting out a chip from a wafer into a rectangular shape, and subsequently transferring the chip to the packaging of TAB or the like or the packaging step of Flip Chip or the like.

In this way, the resist is formed into a pattern shape by the photosensitive resin composition in bump formation. The chemically amplified photosensitive resin composition of the present invention is suitably used as a resist in the cyan or non-cyan electrolytic gold plating step in these steps for producing a bump, e.g. in the step for producing a gold bump.

In addition, in the formation of a LSI element, FPDs such as a liquid crystal display (LCD), a circuit board or the like, electric wiring or the like is formed by plating in addition to the formation of a bump. In this case, copper, nickel, solder, or another metal is used as a plating material for a bump as well as electric wiring, and the like, in addition to the aforementioned electrolytic gold plating. The chemically amplified photosensitive resin composition of the present invention also can be preferably used as a resist in the step for forming such a plating of copper, nickel, solder, or the like, in the plating during bump formation or in the plating step during wiring formation.

Furthermore, it is widely conducted that this plating is applied not only as a single layer but also as continuous multi plating layers of two or more layers by making use of the same resist pattern. The chemically amplified photosensitive resin composition of the present invention is preferably used as a resist in the plating step in which the above-mentioned electrolytic gold plating step and the copper, nickel or solder plating step are continuously conducted, that is, in the multi-layer plating step. Additionally, the order of the gold plating step or the copper, nickel or solder plating step in the multi-layer plating may be arbitrary.

Moreover, the chemically amplified photosensitive resin composition of the present invention can favorably be used also as a plating resist in the formation of a magnetic head or the like.

In this way, the chemically amplified photosensitive resin composition of the present invention is first, if necessary, coated onto a substrate such as a substrate on which an electric conductive layer has been formed with an electric conductive material such as aluminum, copper, silver, gold, palladium or an alloy of two or more metals thereof, and then is pre-baked to form, for example, a photoresist layer of a thick or super thick film. Examples of the substrate include, in addition to the aforementioned silicon substrate, titanium nitride (TiN), nickel, or a permalloy (alloy of iron, nickel, and the like) substrate, and further a soda glass, quartz glass, silicon carbide, titanium carbide, zirconium carbide, boron nitride, aluminum nitride, silicon nitride, silicon, germanium, gallium-arsenic, or gallium-phosphorus substrate, and the like. Then, the composition is pattern exposed to light via a mask, developed using an alkali developer, and thereafter optionally subjected to rinsing treatment, post exposure bake (PEB), and the like. This leads to the formation of a positive resist pattern with a thick or super thick film thickness, which has high resolution and a good shape, and which is suitably used as a plating resist with a thick or super thick film thickness particularly at the time of forming the magnetic pole on a magnetic head or forming the bump. In addition, even in a plating resist of a circuit board and other applications in which conventional positive-working photosensitive resin compositions are used, a chemically amplified positive-working photosensitive resin composition of the present invention is, as a matter of course, suitably used. Furthermore, a chemically amplified positive-working photosensitive resin composition of the present invention has excellent characteristics such as high sensitivity, a high film residual ratio after development, and no generation of scum.

Methods for forming a coating film of the above-described photosensitive resin composition in the present invention include arbitrary methods that are conventionally employed upon coating of a photosensitive resin composition, such as the spin coat process, the roll coat method, the land coat method, the spray coat method, the casting coat method and the immersion coat method. If necessary, the coating film may be formed by, for example, the screen printing method. As the radiation used upon exposure, there are illustrated, for example, ultraviolet rays such as g-line and i-line, far ultraviolet rays such as the KrF excimer laser or the ArF excimer laser, the X rays, electronic beams, and the like. As the developing method there can be utilized a method that is conventionally used upon photoresist development, such as the paddle developing method, the immersion developing method or the oscillation immersion developing method. Examples of the developer include inorganic alkalis such as sodium hydroxide, potassium hydroxide, sodium carbonate, and sodium silicate; organic amines such as ammonia, ethylamine, propylamine, diethylamine, diethylaminoethanol, and triethylamine; and quaternary amines such as tetramethylammonium hydroxide (TMAH); and the like.

For the chemically amplified photosensitive resin composition of the present invention, the optimal treatment conditions including exposure conditions vary depending on the film thickness of a photoresist, an exposure light source, a developer used, etc., but, for example, when a super thick photoresist film of 20 µm or more is exposed and treated with an HBO1000W/D mercury lamp manufactured by Mitsubishi Electric Osram Ltd., used in the Examples indicated below as an exposure light source, the exposure dose is normally from about 100 to about 1000 mJ/cm²·sec. And the development time is from about 60 sec. to about 900 sec. when development is conducted by the dip or paddle method using an organic or inorganic alkali solution that is usually used as a developer.

The chemically amplified photosensitive resin composition of the present invention can also be used for the so-called "dry film" which is got by the steps of applying the photosensitive resin composition to a releasable plastic film, instead of directly applying it to a substrate to be treated, baking to once form a photoresist film on the plastic film, i.e., a temporary support and adhering the formed photoresist film to the substrate to be treated, such as a board. Additionally, the plating solution, the plating method, or the like, used in the above-mentioned plating step, may be any conventionally known solution or any method.

### Advantages of the Invention

The present invention makes it practically possible to provide a chemically amplified photosensitive resin composition which attains both high resolution and high sensitivity, e.g., in a film thickness of 10 µm or more, and which is excellent in coating properties and in line width uniformity and heat resistance of a resist pattern, and which allows a good pattern to be formed. The following examples 1, 2 and 4-6 are reference examples in so far not all components according to claim 1 are applied.

### Best Mode for Carrying Out the Invention

Hereinafter, the present invention will be set forth in more detail by way of Examples, but the embodiment of the invention is by no means limited to these Examples. In addition, in the Examples indicated below, the "weight average molecular weight" means a value as determined by polystyrene standards.

### Example 1

Dissolved in 200 parts by weight of propylene glycol monomethyl ether acetate were 100 parts by weight of a novolak resin (m-cresol: 40%, p-cresol: 60%) having a weight average molecular weight of 7,000,30 parts by weight of a polymer having a weight average molecular weight of 1,000 obtained by polycondensation of triethylene glycol with 2-ethylbutane-1,1-diol, 0.6 part by weight of 2-[2-(5-methylfuran-2-yl)ethenyl]-4,6-bis-(trichloromethyl)-s-triazine as an acid generating agent, and 4 parts by weight of a 1,2-naphthoquinone-(2)-diazide-4-sulfonic acid ester compound of 4,4'-[1-[4-[1-(4-hydroxyphenyl)-1-methylethyl]phenyl]-ethylidene]bisphenol, and the resulting material was stirred and then filtrated with a 1.2 µm filter to prepare a photosensitive resin composition of the present invention. The resulting composition was spin-coated to a 6-inch silicon wafer and the resultant material was baked on a hot plate at 115°C for 7 minutes to obtain a resist film having a thickness of 65 µm. This resist film was exposed through test patterns having a variety of line widths (hole diameters: from 30 to 120 µm; wall widths: from 30 to 120 µm) for 40 seconds (1000 mJ/cm²), by means of the exposure machine MA-200/ML manufactured by Zoom-Microtech Corp. using HBO1000W/D mercury lamp (illuminance at 405 nm: 25 mJ/cm²·sec) manufactured by Mitsubishi Electric Osram Ltd., developed in a 3.0% by weight aqueous solution of TMAH at 23°C for 480 seconds to obtain a resist pattern. The resultant resist pattern was observed for the resist shape and the film surface state. The observation was carried out by confirming the pattern having a hole diameter of 60 µm and a wall width of 60 µm. The results are indicated in Table 1.

The film surface states were judged on the basis of the following criteria.
⊙: Neither surface roughness nor film decrease is present.
○: Some surface roughness and film decrease are observed.
Δ: Both surface roughness and film decrease are considerably observed.
×: Most resist film is dissolved in the developer.

### Example 2

The same procedure as in Example 1 was carried out except for further adding 15 parts by weight of a ternary copolymer of methacrylic acid, methyl methacrylate and n-butyl acrylate (molar ratio being 20:50:30) having a weight average molecular weight of 30,000 to the photosensitive resin composition of Example 1, and the result was obtained in Table 1.

### Example 3

The same procedure as in Example 1 was carried out except for further adding 1 part by weight of tris[4-(vinyloxy)butyl]-trimellitate to the photosensitive resin composition of Example 1, and the result was obtained in Table 1.

### Example 4

The same procedure as in Example 1 was carried out except for developing at 23°C for 200 seconds in a solution prepared by diluting AZ 303N (4.8% by weight aqueous KOH solution) produced by Clariant (Japan) K.K. with distilled water by a factor of 7, instead of developing the patterns in a 3.0% by weight aqueous solution of TMAH at 23°C for 480 seconds, and the result was obtained in Table 1.

### Comparative Example 1

The same procedure as in Example 1 was carried out except for using a photosensitive resin composition which was prepared by dissolving, in 200 parts by weight of propylene glycol monomethylether acetate, 100 parts by weight of a novolak resin, that was the same resin as in Example 1, having a weight average molecular weight of 7,000 and 10 parts by weight of a 1,2-naphthoquinone-(2)-diazide-4-sulfonic acid ester compound of a 2,3,4-trihydroxy-4'-benzophenone, and the result was obtained in Table 1.

### Comparative Example 2

The same procedure as in Comparative Example 1 was carried out except for using 30 parts by weight of a polymer having a weight average molecular weight of 1,000 obtained by polycondensation of triethylene glycol with 2-ethylbutane-1,1-diol instead of 10 parts by weight of the 1,2-naphthoquinone-(2)-diazide-4-sulfonic acid ester compound of a 2,3,4-trihydroxy-4'-benzophenone, 0.6 part by weight of 2-[2-(5-methylfuran-2-yl)ethenyl]-4,6-bis-(trichloromethyl)-s-triazine as an acid generating agent and 15 parts by weight of a ternary copolymer of methacrylic acid, methyl methacrylate and n-butyl acrylate (molar ratio being 20:50:30) having a weight average molecular weight of 30,000, and the result was obtained in Table 1.

### Comparative Example 3

The same procedure as in Comparative Example 1 was carried out except for developing at 23°C for 200 seconds in a solution prepared by diluting AZ 303N (4.8% by weight aqueous KOH solution) produced by Clariant (Japan) K.K. with distilled water by a factor of 7, instead of developing in a 3.0% by weight aqueous solution of TMAH at 23°C for 480 seconds, and the result was obtained in Table 1.

**Table 1**

| | Exposure dose (sec.) | Film thickness (µm) | Pattern shape | Film surface | Remarks |
|---|---|---|---|---|---|
| Example 1 | 30 | 65 | Good | ○ | rectangle |
| Example 2 | 30 | 65 | Good | ○ | rectangle |
| Example 3 | 30 | 65 | Good | ⊙ | rectangle |
| Example 4 | 30 | 65 | Good | ○ | rectangle |
| Comparative Example 1 | 30 | 65 | No resolution | Δ | |
| Comparative Example 2 | 30 | 65 | Bad | × | |
| Comparative Example 3 | 30 | 65 | No resolution | Δ | |

The resist patterns obtained by each of the Examples 1-4 did not show any scum and were good in shape. Table 1 shows that the chemically amplified photosensitive resin compositions of Examples 1-4 are all excellent in pattern shape, sensitivity, and surface state of the pattern. Also, Table 1 shows that the use of the acid generating agent (PAG) provides chemically amplified photosensitive resin compositions of higher sensitivity and higher resolution as compared with the case of using 1,2-naphthoquinone-(2)-diazide-4-sulfonic acid ester compound of a 2,3,4-trihydroxy-4'-benzophenone alone which is a conventionally used photosensitizing agent. This seems to be because the photosensitivity around the board is lost in the case of thick films since a conventional photosensitizing agent absorbs the exposure wavelength light, whereas the system of chemical amplification with a PAG needs only a small amount of an acid generating agent which absorbs the light, which enables pattern formation even in lithography of a thick film and also results in a good shape. Furthermore, using two components of a photosensitizing agent (PAC) containing a quinonediazide group and a PAG, and optionally a crosslinking agent for improving film quality enables an organic developer to exhibit equivalent performance to the case of the use of an inorganic developer. Table 1, Example 3 of the present invention indicates that the use of the two components of a PAC and a PAG, and a crosslinking agent for improving film quality can provide a resist pattern having a good film surface.

### Evaluation of Heat Resistance

Resist patterns obtained by the chemically amplified photosensitive resin compositions of the Examples 1 and 2 were further evaluated for heat resistance.

### Example 5

The photoresist pattern obtained in Example 2 was heat treated at 90°C for one minute on a hot plate. Comparison of the shapes of the resist patterns prior to and subsequent to heat treatment did not show a particular change, with both being a rectangular pattern.

### Example 6

The photosensitive resin composition described in Example 1 was adjusted to thereby obtain a resist pattern by conducting the same procedure as in Example 1. The film residual ratio was 98% or more; the pattern shape was a good rectangular shape. When the resist pattern obtained here was heat treated as in Example 5, a slight distortion of the pattern was observed.

The aforementioned results of Examples 5 and 6 show that the photosensitive resin compositions containing an alkali soluble acrylic resin are particularly excellent in heat resistance.

## Claims

1. A chemically amplified photosensitive resin composition comprising (A) an alkali-soluble novolak resin, (B) a resin or compound which in itself is insoluble or slightly soluble in alkali, but becomes soluble in alkali by the action of an acid, (C) an acid generating agent, (D) a photosensitizing agent containing a quinonediazide group, (F) a compound containing at least two vinyloxyalkylester groups, and (E) optionally an alkali-soluble (meth)acrylic resin, wherein the ratio by weight of said components (A) : (B) : (C) : (D) : (E) : (F) is 100 : 1 to 50 : 0.02 to 10 : 1 to 30 : 0 to 200 : 1 to 10.

2. A chemically amplified photosensitive resin composition according to Claim 1, wherein said resin or compound (B) which is itself insoluble or slightly soluble in alkali, but becomes soluble in alkali by the action of an acid has a structural unit represented by the general formula (I): 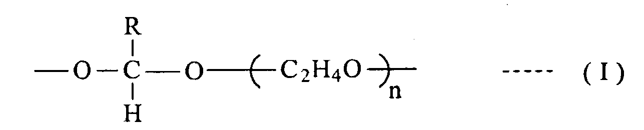 wherein R represents a saturated alkyl group having 1 to 20 carbon atoms and n is an integer from 1 to 10.

3. A chemically amplified photosensitive resin composition according to Claim 1 or 2, wherein the amount of component (E) is from 10 to 50 parts by weight based on 100 parts of the alkali soluble novolak resin (A).

4. A chemically amplified photosensitive resin composition according to Claim 3, wherein said alkali-soluble (meth)acrylic resin (E) contains a structural unit derived from a (meth)acrylic acid, a structural unit derived from an alkylmethacrylate and, optionally, a structural unit derived from styrene.

5. A chemically amplified photosensitive resin composition according to Claim 3 or 4, wherein said alkali-soluble (meth)acrylic resin (E) contains a structural unit derived from a hydroxyalkylmethacrylate, a structural unit derived from an alkylmethacrylate and, optionally, a structural unit derived from styrene.

6. The use of a chemically amplified photosensitive resin composition according to any one of claims 1 to 5 for forming a film on a substrate.

7. The use as claimed in claim 6, wherein the composition is being used in a layer thickness of 10 µm or more.

8. A process for forming a film on a substrate comprising the steps of
a) coating a chemically amplified photosensitive resin composition according to any one of claims 1 to 5 on a substrate and
b) prebaking the coated substrate to form a film.

## Patentansprüche

1. Chemisch verstärkte, lichtempfindliche Harzzusammensetzung, enthaltend (A) ein alkalilösliches Novolakharz, (B) ein Harz oder eine Verbindung, die selbst unlöslich oder wenig löslich in Alkali ist, aber durch Einwirkung einer Säure löslich in Alkali wird, (C) ein Säure erzeugendes Mittel, (D) ein photosensibilisierendes Mittel, das eine Chinondiazidgrupp enthält, (F) eine Verbindung, die mindestens zwei Vinyloxyalkylestergruppen enthält und (E) gegebenenfalls ein alkalilösliches (Meth)acrylharz, wobei das Gewichtsverhältnis der genannten Komponenten (A) : (B) : (C) : (D) : (E) : (F) 100 : 1 bis 50 : 0,02 bis 10 : 1 bis 30 : 0 bis 200 : 1 bis 10 beträgt.

2. Chemisch verstärkte, lichtempfindliche Harzzusammensetzung gemäß Anspruch 1, wobei das Harz oder die Verbindung (B), die selbst unlöslich oder wenig löslich in Alkali ist, aber durch Einwirkung einer Säure löslich in Alkali wird, eine Struktureinheit aufweist, dargestellt durch die allgemeine Formel (I): 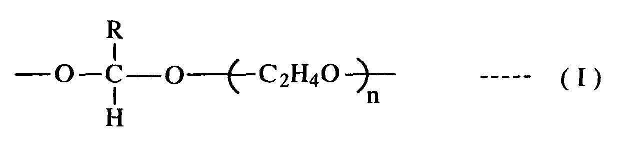 worin R eine gesättigte Alkylgruppe mit 1 bis 20 Kohlenstoffatomen darstellt und n eine ganze Zahl von 1 bis 10 ist.

3. Chemisch verstärkte, lichtempfindliche Harzzusammensetzung gemäß Anspruch 1 oder 2, wobei die Menge an Komponente (E) von 10 bis 50 Gewichtsteilen, basierend auf 100 Teilen des alkalilöslichen Novolakharzes (A), beträgt.

4. Chemisch verstärke, lichtempfindliche Harzzusammensetzung gemäß Anspruch 3, wobei das alkalilösliche (Meth)acrylharz (E) eine Struktureinheit abgeleitet von einer (Meth)acrylsäure, eine Struktureinheit abgeleitet von einem Alkylmethacrylat und, gegebenenfalls, eine Struktureinheit abgeleitet von Styrol enthält.

5. Chemisch verstärkte, lichtempfindliche Harzzusammensetzung gemäß Anspruch 3 oder 4, wobei das alkalilösliche (Meth)acrylharz (E) eine Struktureinheit abgeleitet von einem Hydroxyalkylmethacrylat, eine Struktureinheit abgeleitet von einem Acrylmethacrylat und, gegebenenfalls, eine Struktureinheit abgeleitet von Styrol enthält.

6. Verwendung einer chemisch verstärkten, lichtempfindlichen Harzzusammensetzung gemäß einem der Ansprüche 1 bis 5 zur Bildung eines Films auf einem Substrat.

7. Verwendung gemäß Anspruch 6, wobei die Zusammensetzung in einer Schichtdicke von 10 µm oder mehr verwendet wird.

8. Verfahren zur Bildung eines Films auf einem Substrat, umfassend die Schritte
a) Auftragen einer chemisch verstärkten, lichtempfindlichen Harzzusammensetzung gemäß einem der Ansprüche 1 bis 5 auf ein Substrat und
b) Vorbacken des beschichteten Substrats, um einen Film zu bilden.

## Revendications

1. Composition de résine photosensible chimiquement amplifiée comprenant (A) une résine novolaque soluble en milieu alcalin, (B) une résine ou un composé qui, en lui-même, est insoluble ou légèrement soluble en milieu alcalin, mais qui devient soluble en milieu alcalin via l'action d'un acide, (C) un agent générateur d'acide, (D) un agent de photosensibilisation contenant un groupement quinonediazide, (F) un composé contenant au moins deux groupements vinyloxyalkylester et (E) éventuellement une résine (méth)acrylique soluble en milieu alcalin,
dans laquelle le rapport en poids desdits composants (A) : (B) : (C) : (D) : (E) : (F) est de 100:1 à 50: 0, 02 à 10:1 à 30:0 à 200:1 à 10.

2. Composition de résine photosensible chimiquement amplifiée selon la revendication 1, dans laquelle ladite résine ou ledit composé (B), qui est lui-même insoluble ou légèrement soluble en milieu alcalin, mais qui devient soluble en milieu alcalin via à l'action d'un acide, présente une unité structurelle représentée par la formule générale (I) : 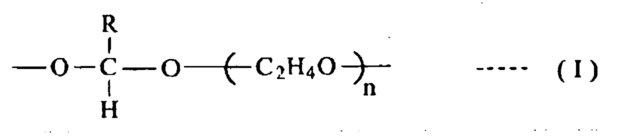 dans laquelle R représente un groupement alkyle saturé ayant 1 à 20 atomes de carbone et n est un entier de 1 à 10.

3. Composition de résine photosensible chimiquement amplifiée selon la revendication 1 ou 2, dans laquelle la quantité de composant (E) est de 10 à 50 parties en poids sur la base de 100 parties de la résine novolaque soluble en milieu alcalin (A).

4. Composition de résine photosensible chimiquement amplifiée selon la revendication 3, dans laquelle ladite résine (méth)acrylique soluble en milieu alcalin (E) contient une unité structurelle dérivée d'un acide (méth)acrylique, une unité structurelle dérivée d'un méthacrylate d'alkyle et, éventuellement, une unité structurelle dérivée du styrène.

5. Composition de résine photosensible chimiquement amplifiée selon la revendication 3 ou 4, dans laquelle ladite résine (méth)acrylique soluble en milieu alcalin (E) contient une unité structurelle dérivée d'un méthacrylate d'hydroxyalkyle, une unité structurelle dérivée d'un méthacrylate d'alkyle et, éventuellement, une unité structurelle dérivée du styrène.

6. Utilisation d'une composition de résine photosensible chimiquement amplifiée selon l'une quelconque des revendications 1 à 5, pour former un film sur un substrat.

7. Utilisation selon la revendication 6, dans laquelle la composition est utilisée au sein d'une couche d'une épaisseur de 10 µm ou plus.

8. Procédé pour former un film sur un substrat comprenant les étapes consistant à :
a) appliquer une composition de résine photosensible chimiquement amplifiée selon l'une quelconque des revendications 1 à 5 sur un substrat et
b) effectuer une précuisson du substrat revêtu dans le but de former un film.
